Europäisches Patentamt

European Patent Office

Office européen des brevets

(11) Veröffentlichungsnummer: **0 515 775 A2**

## (12) EUROPÄISCHE PATENTANMELDUNG

(21) Anmeldenummer: **92102563.1**

(22) Anmeldetag: **15.02.92**

(51) Int. Cl.⁵: **G05D 19/00**

(30) Priorität: **25.05.91 DE 4117136**

(43) Veröffentlichungstag der Anmeldung:
**02.12.92 Patentblatt 92/49**

(84) Benannte Vertragsstaaten:
**AT BE CH ES FR GB IT LI NL SE**

(71) Anmelder: **Klöckner-Moeller GmbH
Hein-Moeller-Strasse 7-11
W-5300 Bonn 1(DE)**

(72) Erfinder: **Rast, Oliver, Dipl.-Ing.
Brahmstrasse 20
W-5309 Meckenheim(DE)**
Erfinder: **Skupin, Johann, Dipl.-Ing.
Lahnstrasse 12
W-5310 Troisdorf(DE)**

(54) **Sollwertgeber zur Vorwahl physikalischer Sollwerte.**

(57) Die Erfindung beschreibt ein Sollwertgeber zur Vorwahl physikalischer Sollwerte, insbesondere elektrischer, mechanischer, optischer oder magnetischer Größen und/oder Funktionen. Der Sollwertgeber

**(1)**

besteht erfindungsgemäß aus einem Vorwahlelement (2), der als würfelförmiger Körper ausgebildet ist, aus einem Sockelelement (3) und einem Abdeckelement (8). Das Vorwahlelement (2) weist Sollwertvorgabestellen auf, die mit Abfrageelementen des Sockelelements physikalische Übergangsstellen bilden. Jeder der sechs Seitenflächen des Vorwahlelements (2) sind unterschiedliche Sollwert- und/oder Funktionsvorgaben zugeordnet. Der Sollwertgeber

**1**

nach der Erfindung ist universell bei geringstem Raumbedarf einsetzbar. Er bietet einfache und vielfältige Einstellmöglichkeiten und ersetzt wirtschaftlich ein Großteil bekannter Sollwertgeber.

Fig.1

EP 0 515 775 A2

Die Erfindung betrifft einen Sollwertgeber zur Vorwahl physikalischer Sollwerte, insbesondere elektrischer, mechanischer, optischer oder magnetischer Größen und/-oder Funktionen, bestehend aus einem Vorwahlelement und einem Sockelelement.

Sollwertgeber der eingangs genannten Art sind in vielfältiger Weise bekannt. In der Druckschrift DE 29 12 139 A1 ist ein Informationsträger für elektronische Daten beschrieben. Der Informationsträger dient zur Aufnahme und Widergabe digital gespeicherter Sprache und Musik und besitzt die Form einer quadratischen Platte. An den Kanten des Quadrates sind Abgriffe für die zu speichernden bzw. bereits gespeicherten Informationen. Die Abgriffe sind derart angeordnet, daß je nach dem mit welcher Kante der Informationsträger in die Halterung eingesetzt wird, die Aufnahme bzw. Abfrage der Informationen an der Stelle des Speichers beginnt, welche dieser Kante entspricht.

Je nach Anwendung bieten sich andere Lösungen wie Stufenschalter oder Vorwahlmodule an um einen gewünschten physikalischen Sollwert vorzugeben. Um beispielsweise verschiedene Werte aus einem Widerstandsnetzwerk vorzuwählen, wird mit einem Drehstufenschalter der gewünschte Wert eingestellt. Diese Anwendung findet sich häufig bei analogen Messgeräten, bei denen der Meßbereich vorgegeben wird. Auch im Bereich der Motorschutz-, Leitungsschutz- und Leistungsschalter werden die einzustellenden Schalter- und Auslöseparameter über Potentiometer oder Stufenschalter eingestellt.

Die verschiedenen Parameterangaben befinden sich dabei auf einer entsprechenden Skalierung der Sollwertvorgabeelemente. Bei den in ihrer Bauweise komplexen Geräten, in denen die Sollwertvorgabeelemente eingesetzt werden, sind wichtige Faktoren der Platzbedarf, die klare und deutliche Erkennung der aktuellen Sollwertvorgabe, die einfache Handhabung der Änderung einer Sollwertvorgabe und die wirtschaftliche Ausführung.

Bei den bekannten Sollwertvorgabeelementen sind diese Voraussetzungen für Hersteller und Anwender nicht befriedigend gelöst.

Aufgabe der Erfindung ist es daher, ein Sollwertgeber zur Vorwahl physikalischer Sollwerte, insbesondere elektrischer, mechanischer, optischer oder magnetischer Größen und/oder Funktionen zu schaffen, der bei geringem Raumbedarf und einfacher sowie wirtschaftlicher Herstellung universell einsetzbar ist, der eine klare und deutliche Visualisierung des aktuell eingestellten Sollwertes vermittelt und eine fehlerhafte Sollwertvorgabe praktisch ausschließt.

Diese Aufgabe wird erfindungsgemäß durch die im kennzeichnenden Teil des Anspruchs 1 angegebenen Merkmale gelöst. Dabei ist es nach der Erfindung besonders vorteilhaft, daß das Vorwahlelement aus einem Gehäuse mit darin befindlichen, ineinander verschachtelten Leiterplatten besteht, wobei das Gehäuse als geometrischer Körper, in Form eines Würfels oder einer Säule, ausgebildet ist, und daß sich in den Flächen- und oder Kantenbereichen des Vorwahlelementes Sollwert- und/oder Funktionsvorgabestellen befinden, die mit Abfrageelementen des Sockelelementes physikalische Übergangsstellen bilden, wobei allen oder einzelnen Flächen und/oder Kanten des Vorwahlelementes eine oder mehrere unterschiedliche Sollwert- und/oder Funktionsvorgaben zugeordnet sind.

Der Erfindungsgedanke stützt sich im wesentlichen auf besonders vorteilhaft. Danach ist der erfindungsgemäße Sollwertgeber nach Anspruch 1 auch als mechanischer, optischer oder magnetischer Sollwertgeber vorzusehen.

Zweckmäßigerweise ermöglicht eine Beschriftung des Vorwahlelements auf der der Steckfläche gegenüberliegenden Sichtfläche die Visualisierung der Funktion oder des Einstellwertes des Sollwertgebers. Ein auf die Sichtfläche des Vorwahlelements aufschnappbares Abdeckelement ist mit einem Sichtfenster versehen, wodurch nur die Beschriftung des aktuellen Sollwertes oder die der aktuellen Funktion des Sollwertgebers sichtbar ist, während die weitere Beschriftung der Sichtfläche abgedeckt ist.

Die Erfindung soll im folgenden anhand eines in der Zeichnung dargestellten Ausführungsbeispieles näher beschrieben und erläutert werden.

Es zeigen

Fig.1 eine perspektivische Darstellung des erfindungsgemäßen Sollertgebers,

Fig.2 eine perspektivische Darstellung des als Würfel ausgebildeten Sockelelements nach der Erfindung,

Fig.3 das Abdeckelement mit dem Sichtfenster zu Visualisierung des aktuellen Sollwertes bzw. der aktuellen Funktionsvorgabe,

Fig.4 eine perspektivische Darstellung des Sockelelements zur Aufnahme des Vorwahlelements,

Fig.5 eine perspektivische Darstellung zweier ineinander verschachtelter Leiterplatten und in Fig.6 und Fig.6a die einzelnen Leiterplatten mit der Bestückung diverser Bauteile.

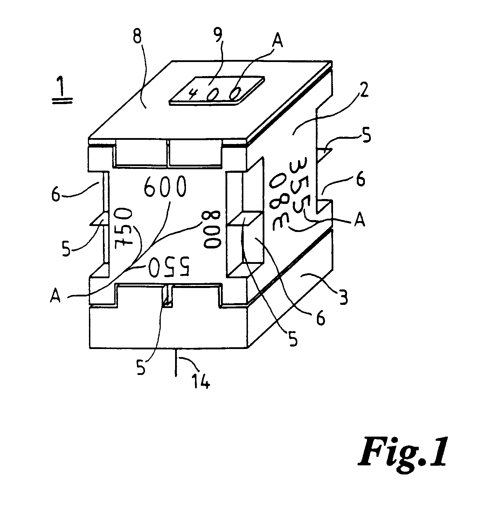

Die Fig.1 zeigt eine perspektivische Darstellung des erfindungsgemäßen Sollertgebers. Der Sollwertgeber

**1**
**‗**

besteht aus dem würfelförmigen Vorwahlelement 2, dem Sockelelement 3 und dem Abdeckelement 8. Das Vorwahle lement 2 weist an allen Kanten Ausbuchtungen 6 auf, aus denen Kontaktierungsflächen 5 austreten. Das Vorwahlelement 2 ist formschlüssig auf das Sockelelement 3 aufgesteckt, wobei die Kontaktierungsflächen 5 der Steckfläche des Vorwahlelements 2 in die Gegenkontakte 7 des Sockelelements 3 eingreifen. Die Vorgabe des aktuellen Sollwertes ist dadurch visualisiert, daß ein Abdeckelement 8 auf der der Steckfläche gegenüberliegenden Sichtfläche aufgeschnappt ist. Durch das Sichtfenster 12 ist der aktuelle Sollwert (400) deutlich erkennbar. Die weitere Beschriftung der Sichtfläche ist durch das Abdeckelement 8 verdeckt. Bei einer Änderung der Vorwahl auf beispielsweise Sollwert (430) ist das Abdeckelement abzunehmen, das Vorwahlelement 2 aus dem Sockelelement 3 herauszuziehen, um 180 Grad zu verdrehen und wieder in das Sockelelement 3 einzustekken. Das Abdeckelement 8 wird wieder aufgeschnappt und im Sichtfenster 9 erscheint der neue Sollwert (430).

Auf diese Weise sind in dieser beispielhaften Ausführungsform insgesamt 12 unterschiedliche Einstellmöglichkeiten mit dem Sollwertgeber

<u>1</u>

möglich. Die Anzahl der Einstellmöglichkeiten läßt sich unter Ausnutzung aller Kanten als Kontaktierungsstellen und je nach Anwendung noch erheblich steigern.

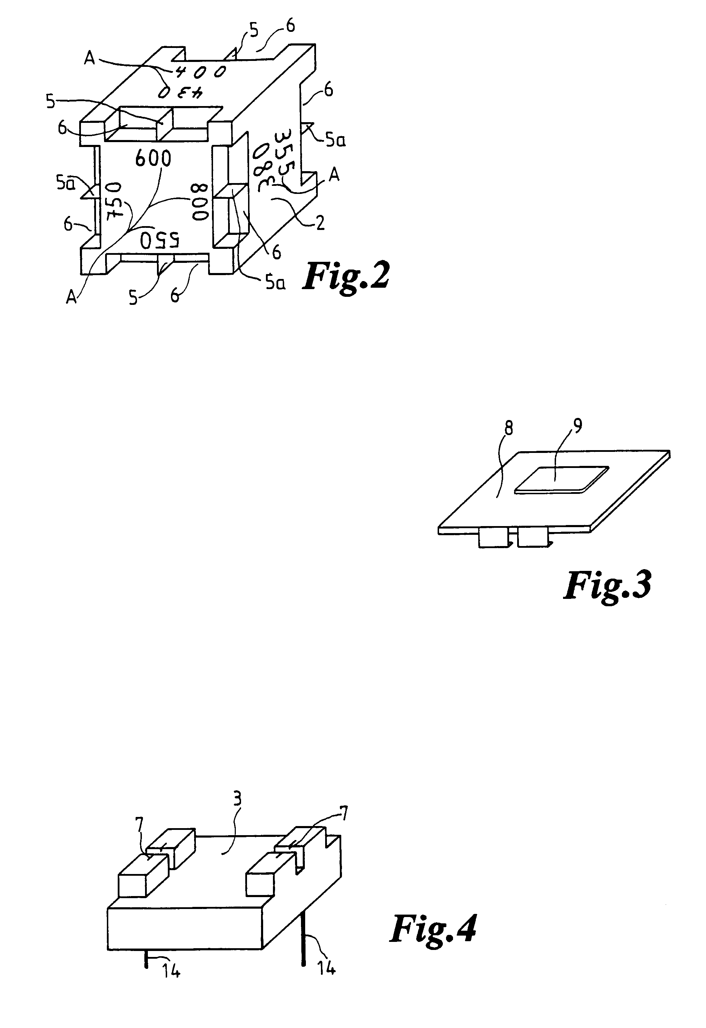

In Fig.2 wird der würfelförmige Körper des Vorwahlelements 2 verdeutlicht. Die Ausbuchtungen 6 an den Kanten des Vorwahlelements 2 geben die Kontaktierungsflächen 5, 5a frei. Hier greifen die Gegenkontakte 7 des Sockelelements 3 ein, wobei die physikalische Übergangsstelle zwischen Vorwahlelement 2 und Sockelelement 3 gebildet wird. Besonders vorteilhaft ist der würfelförmige Körper des Vorwahlelements, da die vielfältigen Anwendungsmöglichkeiten und die einfache und praktische Handhabung bei geringstem Raumbedarf unter Ausnutzung der Dreidimensionalität des Würfels realisierbar ist. Die Art der Sollwertvorgabe ob elektrisch, mechanisch, optisch oder magnetisch ist dabei völlig belanglos, da der Effekt, nämlich die genannten Vorteile, immer dieselben bleiben.

Fig.3 zeigt das Abdeckelement mit dem Sichtfenster zur Visualisierung des aktuellen Sollwertes bzw. der aktuellen Funktionsvorgabe. Das Abdeckelement 8 wird derart auf das Vorwahlelement 2 aufgeschnappt, daß die Beschriftung, die durch das Sichtfenster 9 sichtbar wird, lesbar ist. Der im Sichtfenster 9 dargestellte Wert entspricht immer dem Sollwert, der durch das Einstecken des Vorwahlelements 2 aktiviert wird.

Fig.4 zeigt eine perspektivische Darstellung des Sokkelelements zur Aufnahme des Vorwahlelements. Jede Seite des Vorwahlelements 2 ist formschlüssig in das Sockelelement 3 einsteckbar. Die Anschlußelemente 14 sind in dieser beispielhaften Ausführung lediglich angedeutet. Bei einer Sollwertvorgabe von Widerstandswerten würde hier der gewünschte Wert abgegriffen.

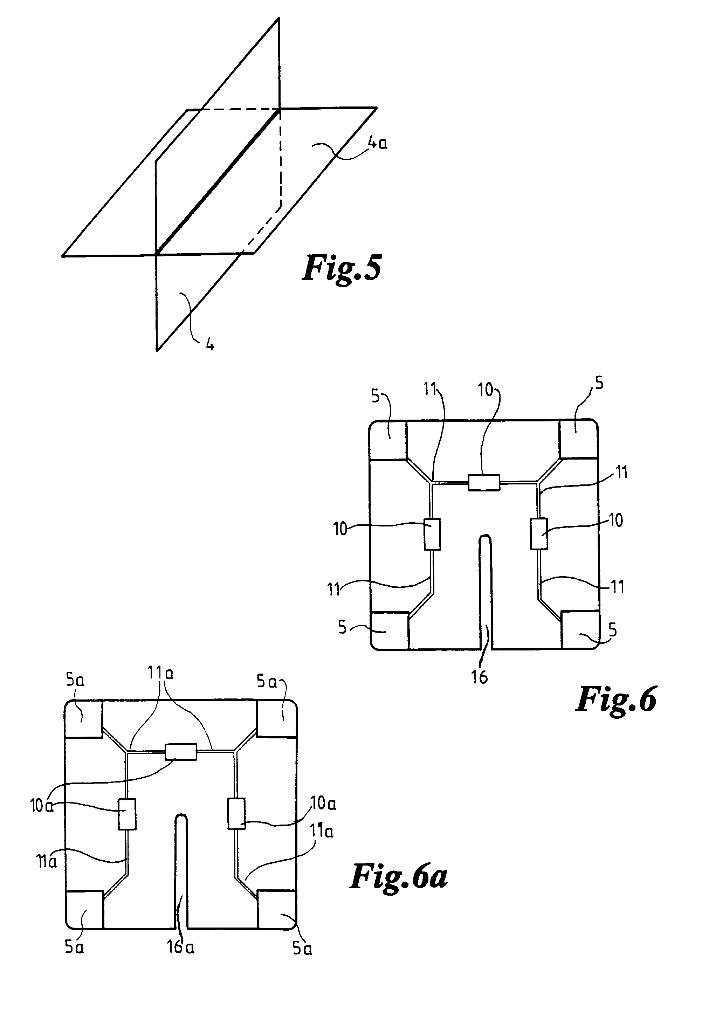

Fig.5 zeigt eine perspektivische Darstellung zweier ineinander verschachtelter Leiterplatten. Zweckmäßigerweise sind die Leiterplatten 4, 4a ineinander verschachtelt, d.h. jede der Leiterplatten 4, 4a hat einen Schlitz 16, 16a, der von der Mitte einer Seite bis zum Zentrum der Leiterplatte reicht. Mittels dieser Schlitze ist es möglich, die Leiterplatten 4, 4a ineinanderzuschieben. Die Leiterplatten sind, wie aus der Fig.6 und Fig.6a ersichtlich mit diversen Bauelementen 10. 10a bestückt, die untereinander mit Leiterbahnen 11, 11a verbunden sind. Die Leiterbahnen enden in den Eckbereichen der Leiterplatten 4, 4a, direkt an den Kontaktflächen 5, 5a.

Der geometrische, in diesem Ausführungsbeispiel würfelförmige, Körper des Vorwahlelements 2 wird dadurch erreicht, daß entweder ein geeignetes Gehäuse die Leiterplatten 4, 4a umfaßt oder daß sie zweckmäßigerweise von einer Vergußmasse umgeben sind, die dem Vorwahlelement 2 die äußere Form eines Würfels gibt.

Das Vorwahlelement 2 ist auch als einfacher Würfel, ohne Leiterplatten oder ähnlichen Elementen entsprechend dem Erfindungsgedanken anzuwenden. Dabei werden auf den Seiten, Kanten oder Eckbereichen des Vorwahlelements 2 optische, mechanische oder magnetische Sollwertvorgabestellen eingerichtet, die von entsprechenden im Sockelelement angeordneten Abfrageelementen abgetastet werden. Unterschiedliche Farbmarkierungen der Seitenflächen des Vorwahlelements 2 sind eine weitere praktische Anwendung, wobei die unterschiedlichen Farben von einer optischen Einrichtung des Sockelelements 3 abgetastet und ausgewertet werden.

**Patentansprüche**

1. Sollwertgeber zur Vorwahl physikalischer Sollwerte, insbesondere elektrischer, mechanischer, optischer oder magnetischer Größen und/oder Funktionen, bestehend aus einem Vorwahlelement und einem Sockelelement, **dadurch gekennzeichnet**, daß das Vorwahlelement (2) aus einem Gehäuse mit darin befindlichen, ineinander verschachtelten Leiterplatten (4, 4a) besteht, wobei das Gehäuse als geometrischer Körper, in Form eines Würfels oder einer Säule, ausgebildet ist, und daß sich in den Flächen- und oder Kantenbereichen des Vorwahlelementes (2) Sollwert- und/oder Funktionsvorgabestellen befinden, die mit Abfrageelementen des Sockelelementes (3) physikalische Übergangsstellen bilden, wobei allen oder einzelnen Flächen und/oder Kanten des Vorwahlelementes (2) eine oder mehrere unterschiedliche Sollwert- und/oder Funktionsvorgaben zugeordnet sind.

2. Sollwertgeber nach Anspruch 1, **dadurch gekennzeichnet**, daß die Leiterplatten (4, 4a) mit aktiven oder passiven elektrischen und/oder elektronischen Bauelementen (10) bestückt sind, die untereinander mittels Leiterbahnen (11) funktionslogisch verbunden sind, wobei die Leiterbahnen (11) an in den Eckbereichen der Leiterplatten (4, 4a) befindliche Kontaktflächen (5) enden, die mit Gegenkontakte (7) im Stecksockel (3) zusammenwirken.

3. Sollwertgeber nach den Ansprüchen 1 und 2, **dadurch gekennzeichnet**, daß die Leiterplatten (4, 4a) von einem Gehäuse umgeben sind, das dem Vorwahlelement (2) die äußere Form des geometrischen Körpers gibt.

4. Sollwertgeber nach den Ansprüchen 1 und 2, **dadurch gekennzeichnet**, daß die Leiterplatten (4, 4a) von einer Vergußmasse umgeben sind, die dem Vorwahlelement (2) die äußere Form des geometrischen Körpers gibt.

5. Sollwertgeber nach den Ansprüchen 1 bis 4, **dadurch gekennzeichnet,** daß mindestens zwei Kanten des Vorwahlelements (2) Ausbuchtungen (6) aufweisen, aus denen die Kontaktflächen (5) der Leiterplatten (4, 4a) austreten und daß Vorwahlelement (2) mit jeweils einer seiner quadratischen Seitenflächen formschlüssig in das Sockelelement (3) einsteckbar ist, wobei die Kontaktflächen (5) der Leiterplatten (4, 4a) mit den Gegenkontakten (7) des Sockelelements (3) eingreifen und kontaktieren und daß durch die Anordnung der Gegenkontakte (7) an den Kanten des Vorwahlelements (2) und die Verschachtelung der Leiterplatten (4, 4a) im Vorwahlelement (2) jeder quadratischen Fläche vier Sollwertvorgaben oder Funktionsvorgaben zugeordnet sind.

6. Sollwertgeber nach Anspruch 1, **dadurch gekennzeichnet**, daß sich an den Kanten und/oder Seiten des Vorwahlelements (2) mechanische Sollwertvorgabeelemente befinden, die in mechanische Abfrageelemente des Sokkelelements (3) greifen.

7. Sollwertgeber nach Anspruch 1, **dadurch gekennzeichnet**, daß die Sollwertvorgabeelemente des Vorwahlelements (2) Reflektionscodierungen sind, die von im Sockelelement (3) befindlichen optischen Abfrageelementen abgetastet werden.

8. Sollwertgeber nach Anspruch 1, **dadurch gekennzeichnet**, daß die Sollwertvorgabeelemente des Vorwahlelements (2) Farbcodierungen sind, die von im Sockelelement (3) befindlichen optischen Abfrageelementen abgetastet werden.

9. Sollwertgeber nach Anspruch 1**, dadurch gekennzeichnet**, daß die Sollwertvorgabeelemente des Vorwahlelements (2) Magnetcodierungen sind, die von magnetischen Sensoren im Sockelelement (3) abgetastet werden.

10. Sollwertgeber nach den Ansprüchen 1 bis 9, **dadurch gekennzeichnet**, daß eine Beschriftung (A) des Vorwahlelements (2) auf der der Steckfläche gegenüberliegenden Sichtfläche (12) die Funktion oder den Einstellwert des Vorwahlelements (2) visualisiert und daß ein auf der Sichtfläche (12) des Vorwahlelements (2) aufschnappbares Abdeckelement (8) mit einem Sichtfenster (9) versehen ist, wodurch nur die Beschriftung (A') des aktuellen Sollwertes oder der aktuellen Funktion des Sollwertgebers

(<u>1</u>)

sichtbar ist, während die weitere Beschriftung der Sichtfläche (12) unsichtbar abgedeckt ist.

Fig.1

*Fig.2*

*Fig.3*

*Fig.4*

*Fig.5*

*Fig.6*

*Fig.6a*